# DEMANDE DE BREVET EUROPEEN

(11) **EP 0 880 310 A1**
(43) Date de publication de la demande: **25.11.1998**
(21) Numéro de dépôt: 98401192.4
(22) Date de dépôt: 18.05.1998
(51) Int. Cl.: H05K 3/44, C25D 11/16, C25D 11/10

(54) **Procédé de fabrication de circuits imprimés sur substrat métallique**

(30) Priorité: 20.05.1997 FR 9706107
(71) Demandeur: SAGEM S.A., 75016 Paris (FR)
(72) Inventeur: Boutin, Xavier, 78150 Le Chesnay (FR); Tola, Dominique, 92370 Chaville (FR); Daniel, Catherine, 95560 Baillet (FR); Hoche, Jean, 76800 Saint Etienne du Rouvray (FR); Poole, Nigel Robert, Wyken, Coventry CV2 5GP (GB); Barnwell, Peter George, Salisbury, Wiltshire SP1 1JD (GB); Fuchs, Sven, 07743 Jena (DE); Hughes, Morris, Solihull, West Midlands B90 2JT (GB); Edwards, Nick, Stockbridge, Hamshire S020 6LF (GB); Dominguez Horna, Carlos, 03203 Sabadell (ES); Masana Nadal, Francisco, 08460 Santa Maria de Palautordera (ES)
(74) Mandataire: Fort, Jacques

(57) **Abrégé**

On constitue un substrat en aluminium pur ou allié au magnésium, qu'on soumet à un traitement thermique de détente, à un décapage et à un nettoyage sur au moins une face à oxyder, on effectue une oxydation anodique d'au moins ladite face du substrat dans une solution d'un acide à faible conductivité électrique, avec une densité de courant comprise entre 1 et 5 A/dm² à une température stabilisée, jusqu'à obtenir une couche oxydée d'épaisseur comprise entre 10 et 200 µm.

## Description

La présente invention a pour objet un procédé de réalisation d'un circuit imprimé, par dépôt de pistes conductrices sur un substrat métallique d'évacuation de chaleur, permettant de dissiper des puissances élevées.

On a déjà proposé de réaliser des circuits intégrés sur un substrat métallique recouvert d'une couche isolante rapportée, telle qu'une pellicule de polymère collé, pour obtenir une dissipation thermique très supérieure à celle que l'on peut réaliser à l'aide d'un substrat en matière plastique ou en céramique. L'un des inconvénients de cette solution est la nécessité d'interposer une pellicule adhésive.

On connaît par ailleurs des procédés d'oxydation anodique de l'aluminium permettant de créer en surface une couche mince d'oxyde augmentant la résistance à la corrosion, aux agressions extérieures. Mais les procédés connus de ce type conduisent à une couche d'oxyde dont la qualité d'isolement est incertaine et qui présente des risques de fissuration aux températures élevées, dues essentiellement à la différence notable des coefficients de dilatation entre la pellicule d'oxyde et l'aluminium sous-jacent.

On a également déjà proposé de former une couche isolante d'oxyde sur des fils électriques par anodisation mais cette application est très différente de la fabrication de circuits imprimés où des surfaces planes de grande dimension sont à oxyder, doivent recevoir des circuits intégrés ou modifiés et peuvent être portés à température élevée.

La présente invention vise à fournir un procédé de fabrication d'un circuit imprimé à substrat métallique oxydé présentant une résistance thermique faible, même comparée aux circuits ayant un substrat métallique revêtu d'une pellicule isolante collée, pouvant supporter des températures élevées sans apparition de défauts tels que des fissures de la couche d'oxyde.

Dans ce but l'invention propose notamment un procédé de fabrication suivant lequel :
on constitue un substrat en aluminium pur ou allié au magnésium, qu'on soumet à un traitement thermique de détente, à un décapage (généralement à l'acide ou à la soude) et à un nettoyage sur au moins une face à oxyder,
on effectue une oxydation anodique d'au moins ladite face du substrat dans une solution d'un acide à faible conductivité électrique, avec une densité de courant comprise entre 1 et 5 A/dm² à une température stabilisée, sous agitation, jusqu'à obtenir une couche oxydée d'épaisseur comprise entre 10 et 200 µm, généralement entre 90 et 140 µm, et
on constitue des pistes conductrices sur l'oxyde, par sérigraphie en couche épaisse ou par photolithographie en couche mince, avant d'implanter des circuits intégrés ou modules.

Ce procédé permet de donner un coefficient de dilatation linéaire élevée à la couche anodisée, et de limiter le risque de fissure ou de décollement lorsque le substrat est porté à une température élevée (500 à 600°C) en fonctionnement. Parmi les applications qui nécessitent de faire fonctionner des circuits imprimés à température élevée, on peut citer la construction automobile, où la température sous capot dépasse souvent 100°C. La tension de claquage atteint 2kV pour une épaisseur d'alumine d'environ 100 µm. La résistance thermique est inférieure à 0,5 K/W.

Parmi les acides à faible conductivité utilisables, on peut citer l'acide oxalique, l'acide citrique, l'acide lactique et l'acide tartrique, utilisés seuls ou en combinaison. Le procédé suivant l'invention est particulièrement utilisable à partir d'un substrat constitué d'aluminium non allié ou d'aluminium contenant une teneur de magnésium inférieure à 1,5 %. Dans la pratique, on obtient de bons résultats à partir d'un substrat en aluminium ayant une teneur en magnésium de 0,12 à 2,5 %, les teneurs en impureté étant inférieures aux valeurs suivantes :
Si < 0,3 %
Fe < 0,05 %
Cu < 0,2 %
Mn < 0,2 %
Cr < 0,1 %
Zn < 0,25 %
Autres < 0,15 %

Le traitement préalable à l'oxydation anodique est essentiel pour obtenir une couche isolante de bonne qualité. Dans le cas de l'aluminium, le traitement de détente peut consister en un recuit à environ 400°C pendant dix minutes, pour relâcher les contraintes. Le décapage et le nettoyage de la surface à oxyder peuvent comporter successivement un dégraissage à l'acide sulfurique, un rinçage suivi d'un séchage, un décapage dans une solution de potasse, un nouveau rinçage suivi d'un séchage, un nouveau décapage à l'acide nitrique pour écarter les oxydes résiduels, et un nouveau rinçage suivi d'un séchage. Le traitement dans une solution potassique étant très exothermique, la température doit être maintenue à une valeur constante - généralement entre 20°C et 50°C - par régulation à quelques degrés près. Un décapage dans une solution à 5 % d'hydroxyde de potassium est pratiquement nécessaire.

Au cours de l'anodisation, il est souhaitable de ne pas dépasser une épaisseur oxydée de 95 µm ; elle ne devrait pas être supérieure à un dixième de l'épaisseur totale du substrat en aluminium.

Des contaminants peuvent subsister dans la porosité du substrat anodisé. Pour écarter ces contaminants, le substrat est nettoyé à l'eau, puis avec un solvant tel que le dichlorométhane ; il est enfin rincé à nouveau à l'eau déminéralisée et séché.

Une fois les pistes conductrices réalisées, le substrat peut être utilisé pour diverses applications, par exemple pour constituer des modules de puissance sous encapsulation plastique, comme support de composant, et en remplacement des substrats céramiques pour des circuits hybrides ayant une forte dissipation thermique.

Les caractéristiques ci-dessus ainsi que d'autres apparaîtront mieux à la lecture de la description qui suit d'un mode particulier d'exécution, donné à titre d'exemple non limitatif. La description se réfère aux dessins qui l'accompagnent, dans lesquels :
- les figures 1A à 1D sont des schémas montrant des étapes successives de fabrication ;
- les figures 2 et 3 sont des schémas destinés à montrer deux utilisations possibles d'un circuit imprimé suivant l'invention.

Il sera essentiellement question par la suite de circuits simple face. On peut toutefois réaliser des circuits double face.

Le produit de départ est constitué par une feuille d'aluminium pur ou à faible teneur de magnésium, à l'état détendu et complètement dégraissé en surface.

Pour permettre l'amenée de courant lors de l'anodisation, le substrat était muni d'un prolongement destiné à être ensuite séparé : une rainure d'amincissement était prévue entre le prolongement et la partie conservée. Ce prolongement était raccordé à l'alimentation électrique. Le bain utilisé était à 7 % d'acide oxalique et maintenu à une température de 24° C. Mais en pratique, on peut utiliser une température stabilisée comprise entre 20°C et 50°C peut être utilisée. La densité de courant était de 30.mA/cm² homogène sur l'ensemble de la surface grâce au mode d'alimentation. La cathode, en aluminium, avait une surface au moins vingt fois supérieure à celle de la feuille traitée. L'oxydation est généralement menée jusqu'à une épaisseur dépassant 95 µm sur un substrat dont l'épaisseur est avantageusement d'au moins 1,2 mm.

Dans ces conditions, on a obtenu une couche diélectrique en oxyde d'aluminium ayant un module de Young relativement faible, compris entre 300 et 50 GPa, et un coefficient de dilatation élevé, supérieur à 8.10⁻⁶K⁻¹. Cette valeur élevée réduit les contraintes à l'interface en cas d'élévation de température du substrat.

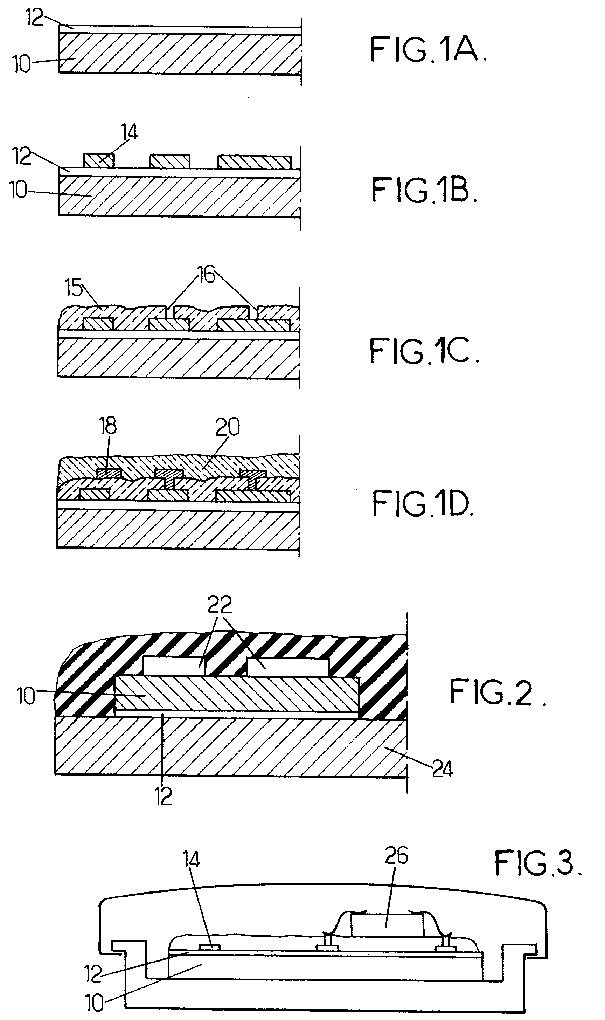

On obtient ainsi un substrat du genre montré en figure 1, constitué par une feuille d'aluminium 10 présentant en surface une couche oxydée 12. L'oxydation est arrêtée alors que l'épaisseur est inférieure au douzième de l'épaisseur totale de la couche.

L'étape suivante de préparation du circuit imprimé consiste en un nettoyage destiné à écarter les contaminants, comme indiqué plus haut. Il est possible de remplir ensuite les pores de la couche oxydée par de l'oxyde de silicium obtenu par décomposition thermique de silane, ou d'autres matériaux organiques ou minéraux, au cours d'une étape supplémentaire.

Au cours de l'étape suivante, une métallisation est déposée sur le substrat. Par exemple les pistes 14 peuvent être formées directement par sérigraphie à l'aide d'une encre à base de cuivre, à travers un pochoir, reproduisant le motif de pistes conductrices (figure 1B). Les liants organiques contenus dans l'encre de sérigraphie sont ensuite éliminés par cuisson. Pour minimiser les contraintes thermiques sur le substrat, il est alors préférable d'utiliser une encre de sérigraphie à cuisson à basse température, d'environ 200°C. On peut également utiliser des pâtes de cermet (céramique-métal) à basse température.

Les pistes peuvent également être formées par dépôt d'une couche et photogravure.

Si l'on souhaite réaliser un circuit multi-couches, une couche diélectrique 15 est déposée sur les pistes conductrices, par sérigraphie ou par une autre technique de dépôt, et des vias 16 sont ménagés (figure 1c). Sur ces vias peut être réalisée une nouvelle couche 18 (figure 1D), recouverte à son tour d'une couche diélectrique 20.

Une autre solution consiste à utiliser un film isolant appliqué par co-cuisson et comportant des zones prédécoupées destinées à établir ultérieurement une continuité électrique entre deux faces métallisées.

Pour assurer une bonne adhérence des couches de métallisation sur les diélectriques, des couches intermédiaires d'accrochage, en chrome ou en titane, peuvent être prévues. Ces couches sont alors réalisées par dépôt sous vide, puis recouvertes d'une couche très mince de protection en or ou en cuivre. Cette couche est éliminée partiellement lors du dépôt de la couche suivante.

On voit que les opérations effectuées sur le substrat sont tout à fait comparables à celles utilisées sur un substrat traditionnel.

Le substrat suivant l'invention peut être utilisé de plusieurs façons. Dans le cas illustré sur la figure 2, le substrat 10 portant des modules 22 est fixé directement, par exemple par collage, sur un puits thermique 24.

Dans le cas de la figure 3, des circuits nus 26 sont maintenus en surface ou reliés au plot du circuit 18 par des fils.

## Revendications

1. Procédé de fabrication de circuits imprimés sur substrat métallique, caractérisé en ce qu'on constitue un substrat en aluminium pur ou allié au magnésium, qu'on soumet à un traitement thermique de détente, à un décapage et à un nettoyage sur au moins une face à oxyder, on effectue une oxydation anodique d'au moins ladite face du substrat dans une solution d'un acide à faible conductivité électrique, avec une densité de courant comprise entre 1 et 5 A/dm² à une température stabilisée, jusqu'à obtenir une couche oxydée d'épaisseur comprise entre 10 et 200 µm, de préférence entre 90 et 140 µm.

2. Procédé selon la revendication 1, caractérisé en ce qu'on constitue le bain d'acide avec un ou plusieurs des acides oxalique, citrique, lactique et tartrique.

3. Procédé selon la revendication 2, caractérisé en ce qu'on utilise un substrat constitué d'aluminium non allié ou d'aluminium contenant une teneur de magnésium comprise entre 0,12 et 2,5 %, les teneurs en impuretés étant inférieures aux valeurs suivantes :
Si < 0,3 %
Fe < 0,05 %
Cu < 0,2 %
Mn < 0,2 %
Cr < 0,1 %
Zn < 0,25 %
Autres < 0,15 %

4. Procédé selon la revendication 1, 2 ou 3, caractérisé en ce que le traitement de détente est un recuit à environ 400°C pendant 10 mn.

5. Procédé selon l'une quelconque des revendications 1 à 4, caractérisé en ce que le décapage et le nettoyage de la surface à oxyder comportent successivement un dégraissage à l'acide sulfurique, un rinçage suivi d'un séchage, un décapage dans une solution d'hydroxyde de potassium, un nouveau rinçage suivi d'un séchage, un nouveau décapage à l'acide nitrique pour écarter les oxydes résiduels, et un nouveau rinçage suivi d'un séchage.

6. Procédé selon l'une quelconque des revendications 1 à 5, caractérisé en ce que l'épaisseur oxydée ne dépasse pas un dixième de l'épaisseur totale du substrat en aluminium.

7. Procédé selon l'une quelconque des revendications 1 à 6, caractérisé en cque la couche d'oxyde et le substrat ont respectivement des épaisseurs d'au moins 95 µm et 1, 2 mm.

8. Procédé selon l'une quelconque des revendications 1 à 7, caractérisé en ce que le substrat oxydé est nettoyé à l'eau, puis avec un solvant, puis rincé à nouveau à l'eau déminéralisée et séché.

9. Procédé selon l'une quelconque des revendications précédentes, caractérisé en ce qu'on remplit les pores de la couche oxydée par de l'oxyde de silicium obtenu par décomposition thermique de silane.
